# EUROPEAN PATENT APPLICATION

(11) **EP 1 308 537 A2**
(43) Date of publication of application: **07.05.2003**
(21) Application number: 02257608.6
(22) Date of filing: 01.11.2002
(51) Int. Cl.: C23C 16/455, C23C 16/04, C23C 16/44, C23C 16/54

(54) **System and method for preferential chemical vapor deposition**

(30) Priority: 01.11.2001 US 335494 P
(71) Applicant: ASML US, Inc., Scott Valley, California 95066 (US)
(72) Inventor: Mayer, Bruce E., Soquel, California 95073-2237 (US); Ingle, Nitin K., Campbell, California 95008 (US); Murphy, Robert S., Santa Cruz, California 95065 (US); Mattson, Colby D., Santa Cruz, California 95062 (US); Kurita, Samuel S., Scotts Valley, California 95066 (US)
(74) Representative: Stoner, Gerard Patrick

(57) **Abstract**

A method and system for chemical vapor deposition in which preferentially depositing chemical species are formed by extending the residence time of reactant gases in the reaction region. These preferentially depositing species deposit more rapidly on the sides and bottoms of trenches on semiconductor wafers and/or other CVD substrates and thus promote the generation of more uniform films that eliminate expensive post-processing steps such as reverse active masking.

## Description

### RELATED APPLICATION

This application claims the benefit of United States Provisional Application Serial Number 60/355,494, filed November 1, 2001, the disclosure of which is hereby incorporated by reference in its entirety.

The present invention relates to a system and method for delivering gaseous chemicals to a surface. More specifically, the present invention provides a system and method for the preferential chemical vapor deposition of chemical species such as the reaction products of tetraethyl orthosilicate (TEOS) and ozone (O₃) as thin films or layers on silicon oxide surfaces relative to silicon-nitride surfaces to promote more uniform coating of topographic features on semiconductor substrates.

### BACKGROUND

Chemical vapor deposition (CVD) is a critical component in semiconductor manufacturing by which a stable film or layer of one or more compounds is deposited on a surface by a thermal reaction or decomposition of certain gaseous chemicals. CVD systems come in many forms. Examples of apparatus for such a process are described in U.S. Patents No. 4,834,020, No. 5,122,391, No. 5,136,975, and No. 6,022,414, all of which are owned by the assignee and incorporated herein by reference. Patents No. 4,834,020 and 5,122,391 describe conveyorized atmospheric pressure CVD (APCVD) systems. Other CVD apparatuses are widely used in the industry, such as plasma-enhanced CVD (PECVD) systems, and low pressure CVD (LPCVD) systems.

One important component of CVD systems is the injector utilized for delivering gaseous chemicals to the surface. The gases must be distributed over the substrate, so that the gases react and deposit an acceptable film on the surface of the substrate. A function of the injector is to distribute the gases to a desired location in a controlled manner. Controlled distribution of the gases maximizes the chance of complete, efficient and homogeneous reaction of the gases, in part by minimizing premixing and prior reaction of the gases. A complete reaction increases the probability of depositing a high quality film. If the gas flow is uncontrolled, the chemical reaction will not be optimal and the result will likely be a film which is not of uniform composition. When the film deposited on a wafer is not of uniform composition, the proper functioning of semiconductors or other devices manufactured from the wafer is impaired. Thus it is important that an injector design facilitates the desired flow of the gases in a controlled manner.

Historically, substantial effort has been invested in maximizing the rate at which reactants and undeposited CVD product compounds are removed from the deposition region. As a mixture of the highly reactive precursor compounds ages, an increasing proportion of secondary and tertiary products is formed. Additionally, as the reaction time lengthens, undeposited primary, secondary, and tertiary products begin to nucleate into small gas-phase, or airborne particles. Deposition of these particles on the substrate may lead to trapping of impurities in the deposited film which can impair the performance of the resulting device or even lead to its failure. Furthermore, deposition of these particles and other extraneous CVD products on the injector apparatus necessitates more frequent maintenance to prevent clogging and unwanted contamination.

Thin films of doped and undoped silicon oxide (also called silicate glass) deposited by CVD find wide application in the production of electronic devices. Proper transistor device operation in CMOS Integrated Circuits (ICs) requires electronic isolation of one transistor from another. Undoped silicate glass (also referred to as USG or SiO_{X}) filled shallow trench isolation (STI) techniques provide significant technological benefits over the previously used method of local oxidation (LOCOS) isolation. In particular, deposition of thin film USG from tetraethyl orthosilicate (TEOS) and ozone (O₃) has found wide acceptance as a trench fill material. Integration into the circuit structure of the deposited SiO_{X} generally requires significant post-deposition planarization, often by means of complicated and expensive chemical mechanical polishing (CMP) techniques.

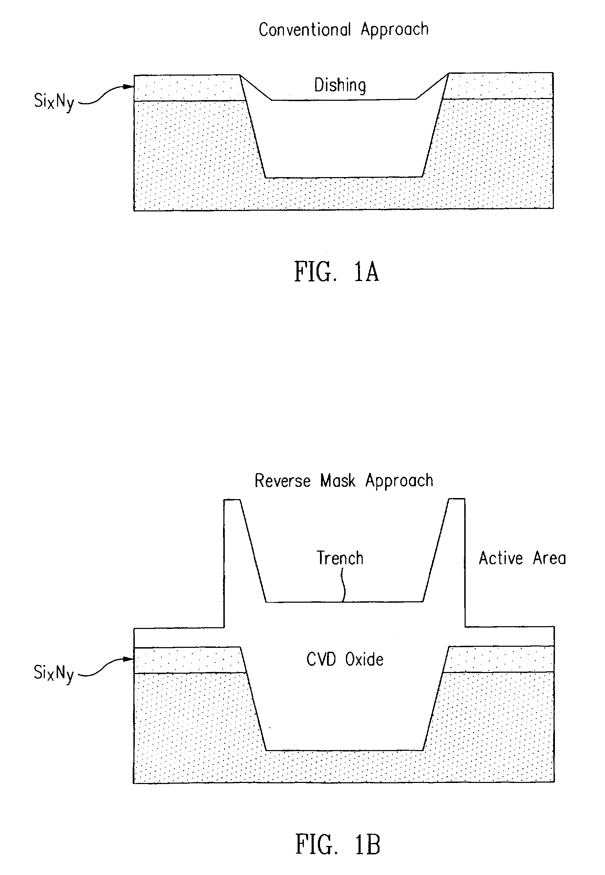

Current CVD methods used to deposit USG on surfaces with physically high and low regions result in film surfaces that reflect the underlying substrate topography. The low film areas coincide with the trenches as might be expected. When using CMP technologies to planarize the surface, uniform polish rates result in "dishing" of the trench surface as indicated in Figure 1A. Dishing can lead to device degradation and depth-of-focus problems during subsequent photolithography steps. One prior art technique to mitigate trench dishing entails a "reverse active" photolithography step to deposit elevated regions of undoped silicon oxide (USG) above the trench edges as shown in Figure 1B. Formation of these reverse-active ridges adds nothing to the circuit structure, but their generation adds an expensive photolithography step to the STI process sequence.

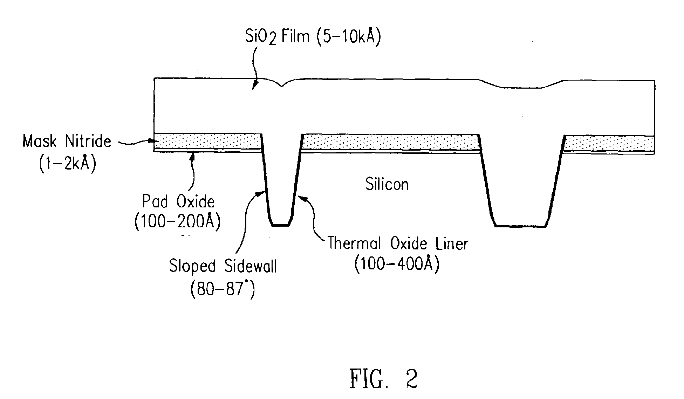

Figure 2 shows a cross-section of the standard STI device structure. As shown, USG deposition occurs on two different surfaces: (1) the nitride (SiN_{Y}) mask layer on either side of the trench and, (2) silicon or thermal silicon-oxide on the trench bottom and sidewalls. The thermal silicon oxide on the trench bottom and sidewalls is often referred to as a thermal-oxide liner. This thermal-oxide liner may be formed before or after USG deposition, depending upon the choice of process sequence. Because of the added expense of extra photolithography steps to achieve reverse-active masking, development of an apparatus and/or method that eliminates the reverse-active masking step is economically desirable. A method and apparatus that causes SiO_{X} to deposit more rapidly on the trench sides and bottom than on the mask nitride would cause the trenches to "fill from the bottom up." Management of such a preference for deposition on silicon or silicon-oxide over silicon-nitride (SiN_{Y}) would thereby result in an as-deposited planar surface that would not require reverse-active masking prior to CMP. Thus, such a method and apparatus for preferential SiO_{X} deposition on silicon (or silicon-oxide) relative to deposition on SiN_{Y} would be quite advantageous relative the current state of the art in CVD systems and methods.

In general, it is an object of the present invention to provide new and useful methods and systems for preferential chemical vapor deposition.

One preferred aspect is to provide a method and system for delivering gaseous chemicals in a substantially controlled manner to a substrate surface for depositing films or layers on certain regions of the substrate surfaces by CVD at a more rapid rate than on the remainder of the substrate surface.

Another preferred aspect is to provide an injector and system to deliver TEOS+O₃ to a substrate to deposit a thin film such that the growth rate of the depositing film is greater on one region of the surface - for instance the bottom and side of a trench - than on a second region of the surface.

In one embodiment of the present invention a chemical vapor deposition system for depositing a film on a substrate is provided. The surface of the substrate includes at least an area of a first material and an area of a second material. The system includes an injector that provides one or more gases to a reaction region. The gases have a residence time in the reaction region that is sufficient to promote formation of one or more target chemical species by reaction of the one or more gases. These target chemical species deposit on the first material on the substrate surface at a faster rate than on the second material.

A further embodiment of the present invention provides a chemical vapor deposition system for depositing a film on a substrate having at least an area of a first material and an area of a second material. The system includes at least one injector that provides one or more gases, a reactor region adjacent to the injector that receives the one or more gases, an exhaust passageway that removes gases from the reaction region, and a translation mechanism for moving the substrate through the reaction region at a lateral velocity. Gases are removed from the reaction region through the exhaust passageway at a rate that provides a residence time for the gases in the reaction region that is sufficient to promote formation of one or more target chemical species that deposit on the first material on the substrate surface at a faster rate than on the second material on the substrate surface. As the substrate is moved through the reaction region by the translation mechanism, its surface is exposed to the one or more target species for a desired period.

In yet another embodiment of the present invention, a method is provided for preferentially depositing a film on a substrate surface having at least an area of a first material and an area of a second material. One or more reactant gases are delivered at a first flow rate to a reaction region which has a volume. These reactant gases react to form a gas mixture of one or more target chemical species and one or more waste gases. The gas mixture is exhausted from the reaction region at an exhaust flow rate. The ratio of the exhaust and first flow rates relative to the reaction region volume are controlled such that the residence time of the one or more reactant gases in the reaction region is sufficient to promote formation of the one or more target chemical species from the one or more gases. The one or more target chemical species deposit at a faster rate on the first material on the substrate surface than on the second material. The substrate is translated at least once through the reaction region to expose the surface to the one or more target chemical species.

In yet another embodiment of the present invention, a method is provided for preferentially depositing a film on a substrate as part of a shallow trench isolation (STI) wafer processing process; the methods disclosed herein are preferably used for such a process.

### BRIEF DESCRIPTION OF THE DRAWINGS

Other objects and advantages of the present invention will become apparent upon reading the detailed description of the invention and the appended claims provided below, and upon reference to the drawings, in which:
Figures 1A and 1B are schematic diagrams illustrating the dishing problem and how it results in the need for an expensive "reverse active" mask step used in a conventional SiO_{X}-filled shallow trench isolation (STI) process sequence.
Figure 2 is a cross-sectional diagram showing the typical shallow trench isolation device structure.
Figure 3 is a schematic diagram of a CVD system according to one embodiment of the present invention providing an extended reaction time for reactant gases to react prior to being exhausted through an exhaust passageway according to one embodiment of the present invention.
Figures 4A and 4B are cross sectional drawings of a uni-directional and a bi-directional injector embodiment, respectively, of the system of the present invention.
Figure 5 is a cross sectional side elevated view of one embodiment of the system of the present invention having two outlet, bi-directional injector assemblies.
Figure 6 is a graph of the theoretical concentrations of chemical species as a function of distance from the injector outlet for a prior art CVD system and injector and a CVD system and injector embodying the present invention.
Figures 7A and 7B are cross-sectional diagrams illustrating the deposition region reactive gas flow path differences between the prior art and an embodiment of the invention;
Figures 8A and 8B depict the contrasts in complexity of the STI process sequence for a conventional process and a process sequence embodying the present invention using the system shown in Figure 5.
Figure 9 is a schematic diagram illustrating one example of how a bi-directional CVD apparatus embodying the invention may be configured to perform etchant cleaning, embodying an aspect of the present proposals.
Figure 10A and Figure 10B are SEM photos and a chart showing results of an attempt to produce preferential deposition using a prior art injector.
Figure 11A and Figure 11B are SEM photos and charted results for preferential deposition using the method and system according to one embodiment of the present invention.
Figure 12 is a schematic diagram of the injector configuration used to produce the data shown in Figures 11A and 11B.
Figure 13 shows Computational Fluid Dynamics (CFD) modeling results for the system of Figure 4A.
Figure 14 shows CFD modeling results for the system of Figure 4B.
Figure 15 shows additional CFD modeling results for one embodiment of the system of the present invention employing a bi-directional injector.

### FURTHER EXPLANATIONS; OPTIONS AND PREFERENCES

Since chemical reactions are kinetic processes, timing is important to formation of the final product(s) from the source material. Chemical "residence time" is a commonly used term that broadly describes the effect of chemical kinetics. The residence time may be determined by calculating the amount of time a chemical molecule resides in the reaction region - generally calculated as the ratio of a volume divided by a volumetric flow rate. In a CVD system, which more closely resembles a plug flow reactor, the first order residence time may be calculated as the product of the gas flow velocity and the length of the gas flow path within the reaction region by assuming a constant cross sectional area in the reaction region. Computational fluid dynamics (CFD) models are typically employed to yield more precise residence time calculations.

The inventors have discovered that a linear injector in which gases are delivered along a length in a line-like manner offers the opportunity for substantial control of the chemical residence time. A well designed linear injector promotes uniform gas flow along the entire line length, such as is described in U.S. Patent No. 6,022,414. A linear injector based CVD system produces a berm-like deposition print that is uniform along its substantial length on a static substrate or wafer. Moving the substrate through the deposition region with a smooth translating motion results in every point on the substrate being exposed to a similar chemical environment which leads to substantially uniform deposition rates over the entire substrate surface. This characteristic fundamentally distinguishes linear injectors from other CVD gas distribution heads such as, for instance "shower head" injectors which deliver reactive gases over a two-dimensional area at substantially uniform rates. Shower head-type CVD injectors may suffer from deposition irregularities caused by nonuniform removal rates for undeposited airborne products and other reaction byproducts.

Of significant advantage the present proposals provide for control of the chemical residence time to promote selective or preferential deposition on different regions on a substrate. According to a method and system proposed herein, chemical residence time is controlled by one or both of the gas velocity (through flow rate control) and the area of the deposition zone or reaction region (through the physical design). The degree to which residence time is controllable by gas velocity modulation is limited by other important process considerations such as film deposition uniformity, particulate generation, and other potential limitations. If the deposition process requirements call for residence time in excess of what can be achieved by reducing the gas flow velocity, the length of the reaction region may be increased to obtain greater residence periods.

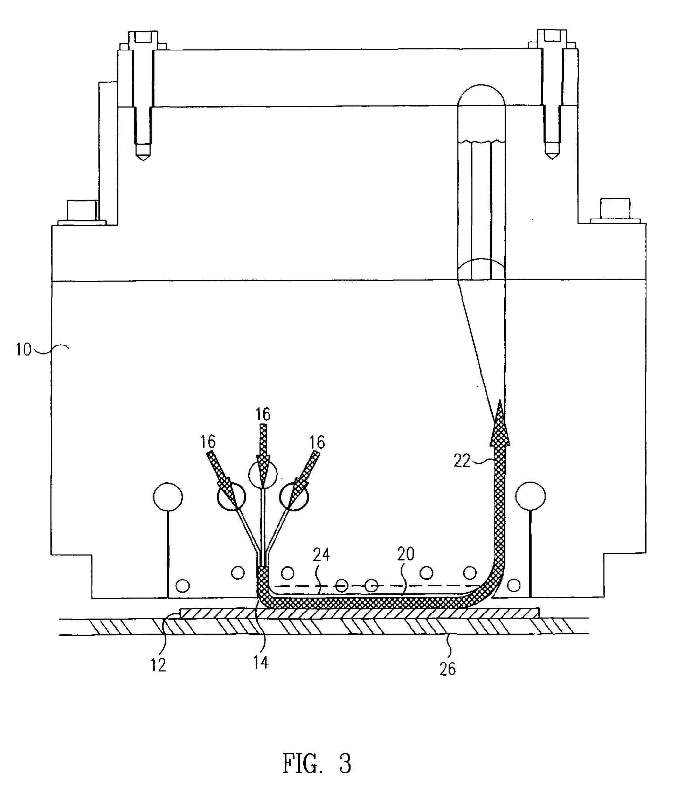

Certain specific features and advantages of the present proposals are illustrated in Figures 3, 4, and 5 in which a novel CVD system 10 deposits a film on a substrate 12 and includes one more injectors 14 and a reaction region 20.

One embodiment of the present invention provides a chemical vapor deposition system 10 for preferentially depositing a film on a substrate surface 12. The substrate surface has at least an area of a first material and an area of a second material (not shown). An injector slot 14 delivers one or more gases provided by, for example, one or more gas delivery tubes 16, to a reaction region 20 such that the reactive gases have a residence time sufficient to promote formation of one or more target chemical species by reaction of the gases. These one or more target chemical species deposit on the first material on the substrate surface 12 at a faster rate than on the second material.

The residence time of the gases in the reaction region 20 is preferably controlled as a function of the volume of the reaction region 20 and a gas exhaust rate from the reaction region 20. Gases are preferably removed from the reaction region 20 by at least one exhaust vent 22. The reaction region may be bounded by at least a top wall and a substrate support 26 on which a substrate or wafer is supported. The injector slot 14 is preferably situated such that the one or more gases are delivered though the top wall 24. A conveyor mechanism (not shown), such as for example a conveyor belt, one or more translatable boats or trays, a series of rollers, or some other similar system for laterally translating an item is preferably included to translate the substrate 12 and substrate support 26 through the reaction region 20 at least once such that the surface of the substrate 12 is exposed to the one or more target chemical species for a desired period or time.

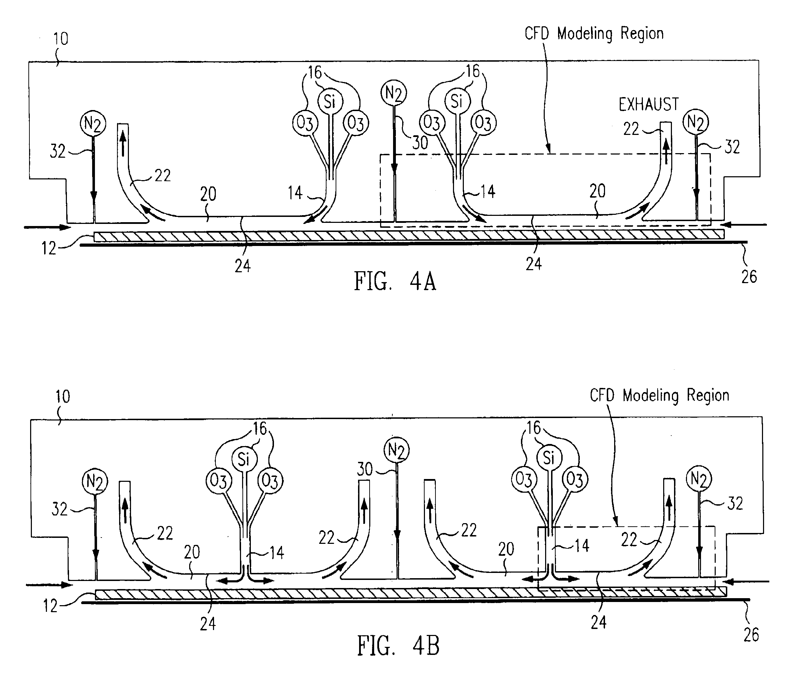

Figures 4A and 4B are schematic diagrams illustrating uni-directional (Figure 4A) and bi-directional (Figure 4B) embodiments of the present invention as part of a larger CVD system. In the uni-directional example, two injector slots 14 are provided. However, additional sequential injector slots may be added to increase the deposition rate for each pass of a substrate or wafer through the CVD processor path. Each injector slot 14 feeds into a reaction region 20 from which gases are exhausted through an exhaust vent 22. In this example, the flow directions through the two reaction regions 20 are mirrored. Flow of gases through each reaction region 20 occurs in a single direction from the injector slot 14 to a single exhaust vent 22. Gas flow directions are shown in Figures 4A and 4B by arrows. Preferably, a center buffer gas injector 30 providing inert gas, such as for example nitrogen or argon, is provided between each reaction region 20 to control and restrain the flow of gases and to enhance smooth, laminar flow through the reaction region 20. At each end of the sequence of reaction regions 20, there is an additional end buffer gas injector slot 32. Gases are provided to the injector slots 14 by one or more gas delivery tubes 16. In the example illustrated in Figure 4A, two gas delivery tubes 16 provide ozone and one tube 16 provides an organosilicon compound such as TEOS. However, other combinations of gases and gas sources and other methods of providing gases to the injector 14 are compatible with this system as well. In the CVD system shown in Figure 4A, the flow rate of inert gas from the center buffer gas injector 30 is approximately double that of the two end buffer gas injectors 32. Some additional flow into the reaction regions may be provided as shown by the horizontal arrows at either end of the system. In one preferred embodiment, the central buffer gas injector slot 30 provides nitrogen at approximately 5 standard liters per minute (SLPM) and the two end buffer gas injectors 32 provide nitrogen at approximately 2.5 SLPM. Additional gas flow into the CVD region from the wafer load and unload regions of the system (not shown) may be provided at a gas flow rate of approximately 1 SLPM.

To deposit a layer or film, a substrate such as a semiconductor wafer 12 is supported on a substrate support 26 and translated through the series of reaction regions 20 by a translating mechanism (not shown). In a preferred embodiment, the distance between each injector slot 14 and its corresponding exhaust vent 22 is in the range of approximately 60 to 80 mm and preferably approximately 67 mm. Spacing between adjacent injectors 14 is in the range of approximately 40 to 55 mm and more preferably approximately 45 mm.

In the bi-directional embodiment of the present invention illustrated in Figure 4B, a CVD system with two injector slots 14 is shown. As in the uni-directional embodiment, two injector slots 14 providing gases to two distinct reaction regions 20 are shown. Gases, in this example ozone and an organosilicon compound such as TEOS are provided to each injector by one or more gas delivery tubes 16. However, the present invention is in no way limited to a system with only two reaction regions or to a system for reacting and depositing films generated from TEOS and ozone feed gases. Additional injector slots 14 feeding additional reaction regions 20 may be added to increase film deposition rates for each pass of the substrate depending on size limitations for the CVD tool. A center buffer gas injector slot 30 is provided between each reaction region 20 providing an inert gas or gases such as nitrogen or argon or another suitable gas at a flow rate that is approximately double the flow rate of one or more inert gases supplied by end buffer gas injector slots 32 located at either end of the CVD processing region. The bi-directional embodiment of the present invention differs from the uni-directional system in that gas flows through each reaction region 20 from an approximately centrally located injector slot 14 to two exhaust vents 22, one on each end of the reaction region 20. Gas flow through each reaction region is in two directions from the central injector slot 14. As in the uni-directional embodiment, gas flow from the center buffer gas injector slots 30 may be preferably approximately 5 SLPM. Gas flows from the end buffer gas injector slots 32 are preferably approximately 2.5 SLPM. Additional gas inflow from the load and unload regions of the tool is preferably approximately 1 SLPM in this example. In a preferred embodiment of the bi-directional injector, the distance between each injector slot 14 and its corresponding exhaust vent 22 is in the range of approximately 25 to 100 mm, and preferably approximately 35 mm. Spacing between adjacent injectors 14 is 70-200 mm, and preferably approximately 100 mm

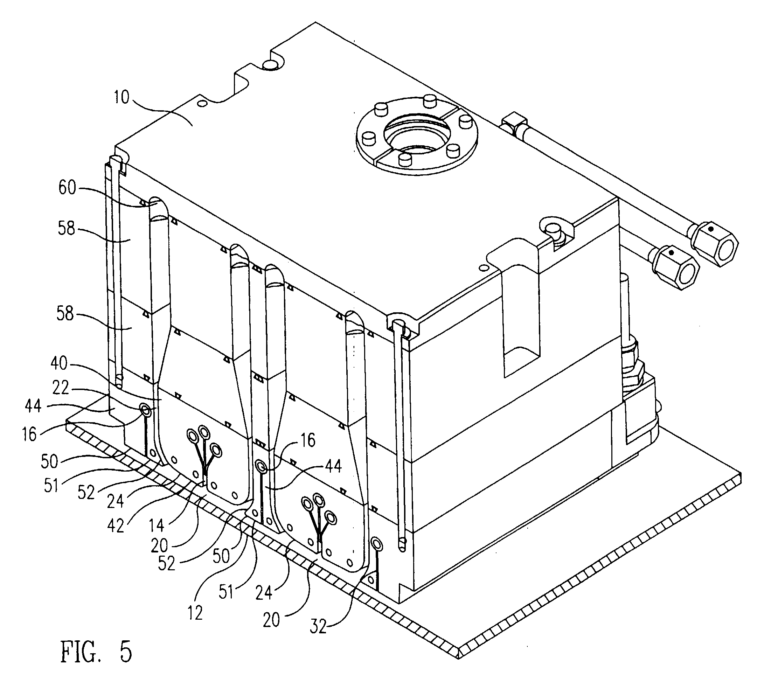

Additional preferred features are illustrated in Figure 5 as part of a more complete CVD system incorporating two adjacent bi-directional injector systems. The system depicted in Figure 5 is also adaptable to the uni-directional embodiment described above. In both the uni-directional and bi-directional embodiments, it is preferred that the injector slot 14 be formed as an elongated slot in a gas delivery surface that provides uniform flow of gases along its substantial length. Likewise, the one or more exhaust vents 22 and the center 30 and end 32 buffer gas injectors are also ideally formed as elongated slots in the top wall bounding the reaction region. Gas flow into and out of the reaction region 20 via these elongated slots is preferably uniform along the substantial length of the slot or slots and flow through the reaction region is directed substantially along the axis perpendicular to the elongated slots which are all arrayed substantially in parallel.

A conveyor mechanism such as a conveyor belt, a moveable boat or tray system, a bed of controllable rollers, or other suitable means for translating a substrate in a lateral direction is preferably provided. This conveyor system is capable of moving the substrate through the reaction region at a lateral velocity such that the substrate surface is exposed to the one or more target chemical species for a desired period. In this manner, the exposure of the first and second materials on the substrate surface to the target chemical species is a function of both the residence time of gases in the reaction region, the lateral velocity of the substrate through the reaction region, and the number of times the substrate is passed through the reaction region.

In a further preferred embodiment of the uni-directional and bi-directional injector system discussed above, each of a plurality of injector members 40 is formed of an elongated injector slot 14 in a single elongated member 40 that has at least two end surfaces and an elongated gas delivery surface. The elongated gas delivery surface also preferably includes two rounded side regions 42 and a center recessed region or injector 20 from which the gases emanate. Gases are supplied to within each injector member 40 by one or more gas delivery tubes 16. The total width of the rounded side regions 42 and the center region is in the range of approximately 50 to 200 mm. The gas delivery surface extends along the length of the elongated member 40 directly facing the reaction region 20. Each of the plurality of injector members 40 is separated from its neighboring injector member 40 or from an adjacent substrate load or unload region of the system by a vent member 44. Each vent member 44 incorporates either a center 30 or an end 32 buffer gas injector slot supplied with inert gas via one or more gas delivery tubes 16. Each vent member 44 comprises a single member with front, back, top and end surfaces, and a bottom external surface 50. The external surface 50 generally includes a planar region 51 and at least one contoured side region 52. The contoured side region 52 is placed adjacent to and spaced apart from the rounded side region 42 of the neighboring injector member such that a rounded exhaust vent 22 is formed between the injector member 40 and the vent member 44. The inventors have found that such a configuration reduces recirculation of gases and promotes laminar flow throughout the reaction region 20. Gases exhausted from the reaction regions 20 of the plurality of injector members 40 are removed from the system through an exhaust manifold 58 with an exhaust outlet line 60. All buffer gas injector slots 30, 32 are positioned to exit the external surface 50 of their respective vent members 44 in a perpendicular manner in the present embodiments. The exhaust manifold 58 has been refined relative to the prior art manifold through the addition of a diverging "chimney" section. Additionally, exhaust outlet line 60 in the injector of the present embodiments is preferably divided into two separate passages. This permits introduction of an etch cleaning gas in one passage, and simultaneous exhaust of the reactive gas byproducts in the other passage.

An aspect of the present invention is a method for preferentially depositing a film on an area of a first material on a substrate surface at a faster rate than on an area of a second material. Reactant gases are delivered to a reaction region at a first flow rate. In the reaction region, which has a volume, the reactant gases react to form a mixture that includes chemical species that deposit preferentially on the first material on the substrate surface relative to the second and other materials on the surface. Also included in the mixture are other waste gases such as undeposited silicon oxides and other reaction byproducts and unreacted reagents. This gas mixture is exhausted from the reaction region at an exhaust flow rate, preferably through one or more exhaust passageways. By controlling the ratio of the exhaust flow rate relative to the volume of the reaction region, the residence time of the one or more reactant gases in the reaction region can be controlled to promote production of the target species that deposit on the first material on the substrate surface at a faster rate than on the second material. Once the flows of gases supplied by the injector and exhausted through the exhaust passageways are stabilized and a steady-state profile of chemical species concentrations as a function of the distance between the injector and the one or more exhaust passageways is established, the substrate is translated through the reaction region one or more times to expose its surface to the one or more target species.

The one or more reactant gases are preferably delivered via a linear injector that is fed by one or more gas delivery tubes providing an organosilicon compound such as for example TEOS and an oxidizing compound such as for example ozone. If a linear injector slot is used, the exhaust passageways are preferably also elongated slots in an elongated member as described above in reference to the uni-directional or bi-directional CVD system embodiments.

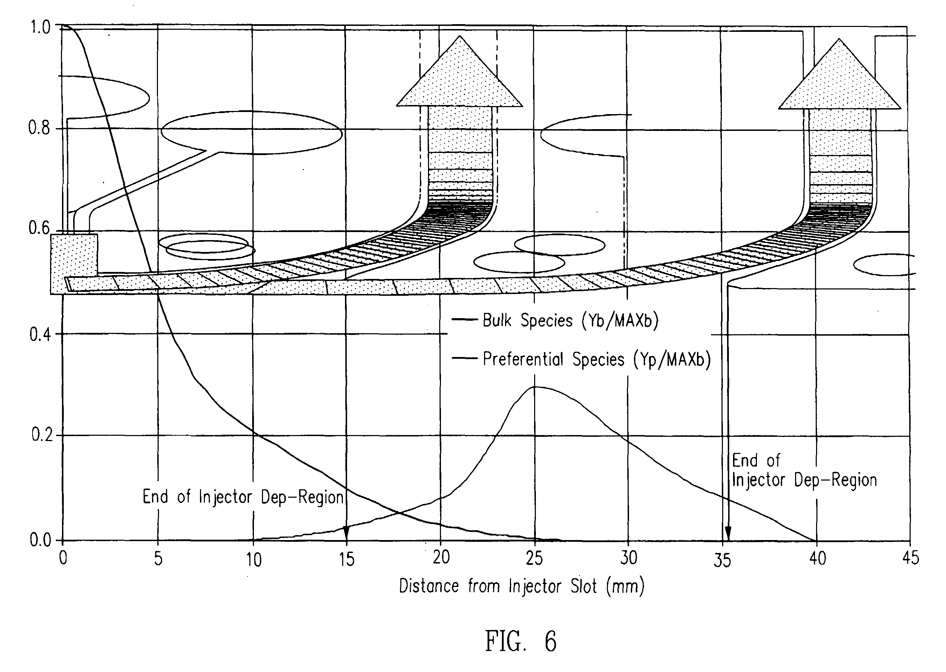

Increasing the reaction region size is fundamentally limited in non-linear injectors because the reaction region cannot be substantially larger than the substrate to be processed. In a linear injector system, it is possible to decouple the reaction region size from the size of the substrate because the substrate can be translated through the reaction region. The formation of slower-forming chemical species that are responsible for preferential deposition should peak at some distance from the gas inlet as shown conceptually in Figure 6. The conversion of, for instance, TEOS and O₃ reactants to SiO_{X}/SiO₂ most likely proceeds through a series of intermediate chemical species. It is likely that the species responsible for preferential deposition form later in time than the non-preferential species. The wider reaction region of the injector system and method of the present invention relative to the prior art as shown in Figure 6 allows more time for formation of these preferential deposition species.

If the extended residence times necessary to produce chemical species with preferential deposition properties exceed the size of the substrate, then the desired species will form beyond the margins of the substrate and therefore not be deposited. Thus, formation of the required deposition species beyond the substrate is of no practical value. This is an additional limitation of shower head-type reaction regions in which the entire substrate is exposed to the deposition region simultaneously. The reaction region in a "showerhead" type is already slightly larger than the substrate, and the substrate resides in the center. Increasing the size of the reaction region in such an injector system does not result in substantial exposure of longer residence time species to the substrate.

Coupling of a linear injector deposition region with "full pass" deposition provides a solution for the substrate size limited deposition region. Full pass coating permits a deposition region with a gas flow path that is not limited by the size of the substrate. In full pass deposition the CVD gases are sent to the injector and then to the reaction region where they are allowed to time stabilize while the hot substrate waits outside the deposition area. After gas stabilization - evidenced by development of a steady state concentration profile as a function of distance through the reaction region - a linear translation system such as for instance a conveyor belt, a movable tray or boat, a series of controllable rollers, or some similar mechanism for supporting and moving a substrate, passes the substrate through the deposition region until the substrate passes fully through the deposition zone. After completely emerging from the deposition region, the substrate travel direction may be reversed, and the substrate may again fully retranslate through the deposition region. This "back and forth" translation can be repeated as many times as needed to build up the required film depth.

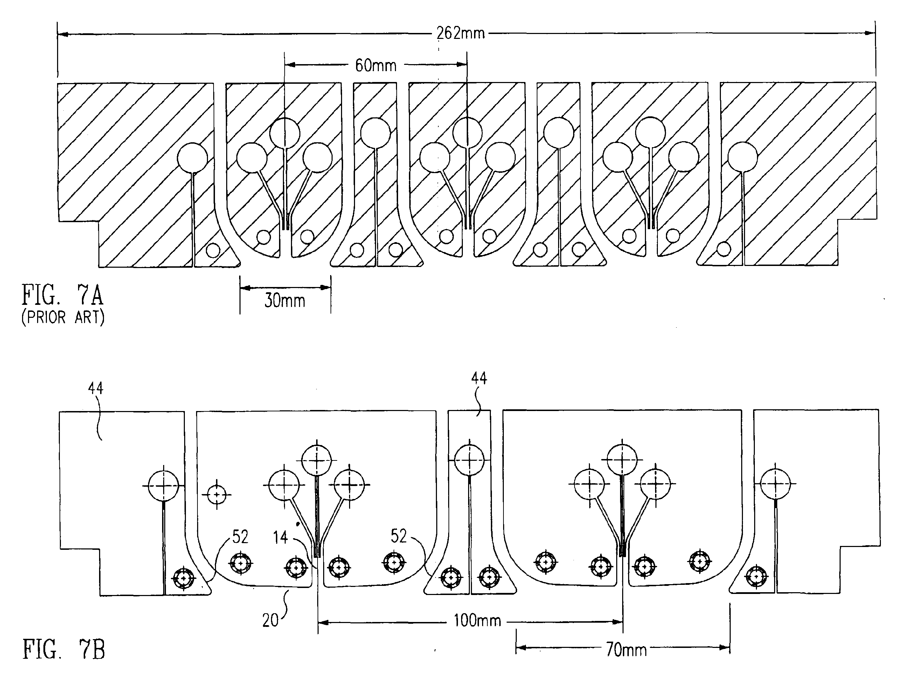

Figures 7A and 7B illustrate several differences between prior art linear injector based CVD systems, such as for example, the injector described in U.S. Patent No. 6,022,414, and a representative bi-directional injector embodiment of the present invention.

According to the present invention, the deposition or reaction region 20 has a width characterized by the "nose to nose" distance between opposing contoured side regions 52 of the vent members 44. This width is significantly increased thus increasing the residence time of the gases which is in contrast to the prior art which teaches maximizing the rate of removal of the gases from the deposition region. For example, the width of the nose-to-nose distance is about 30 mm in the prior art system shown in Figure 7A but is about 70 mm or greater in the present invention as shown in Figure 7B. Longer or shorter flow paths may be used in the system of the present invention depending on the gases and the substrate to be used in a given application. In one embodiment, the width of the reaction region 20 is in the range of approximately 50 to 200 mm. More preferably the width of the reaction region 20 is in the range of about 65 to 100 mm. The important parameters governing the spacing of the contoured side region 52 of the vent member 44 of the system of the present invention are the residence time of the reactive gases in the reaction zone necessary to promote formation of preferentially depositing species and the injector and exhaust flow rate ranges over which laminar, non-recirculating flow can be maintained through the reaction region 20, all of which can be determined by those of ordinary skill in the art without undue experimentation based on the teachings herein.

The rounded side regions 42 of the present invention exhibit an important development of a preferred embodiment of the present invention. In the prior art, the reaction region is much narrower, and the contours of the exhaust path are more sharply curved than in the present invention. The reasons for the smaller rounded side region 140 in the prior art injector apparatus may be understood by referring to the modeling results from the conceptual deposition chemical species model shown in Figure 6. The prior art injector system is designed to promote uniform bulk deposition on the entire surface of the substrate. As such, it is advantageous in that application to exhaust the reactive gas mixture from the deposition region before preferentially deposited species are formed in high yield because these species may tend to accumulate on certain regions of the substrate surface at a faster rate than on other area of the substrate surface. In contrast, the present invention actively seeks to promote formation of these species to enhance deposition on certain regions of the substrate surface, such as for instance exposed SiO_{X} on the sides and base of surface trench features, relative to other regions of the surface such as, for instance unetched areas of a SiN_{Y} mask layer. Expansion of the reaction region 20 promotes formation of the chemical species that are ultimately responsible for preferential deposition. Longer deposition regions of up to approximately 300 mm separation between adjacent injector slots 14 may be preferred for use in alternative injector bodies.

The mechanism of the chemical reaction of TEOS with O₃ to form SiO_{X} is extremely complex. For instance, the ASML US Inc. Thermal Systems TEOS-O₃ Chemistry Model contains well over 30 chemical reactions. Only a handful of these intermediate chemicals contribute to preferential deposition. Thus, maximizing their formation was the key to the desired preferential behavior. Moreover, apart from process conditions such as deposition temperature and pressure, the "residence time" of the chemicals in the deposition region was expected to be significant to the formation of the chemical species that produce preferential deposition. The physical structure of the chemical gas injector affected residence time in several ways. A narrow deposition region, such as in U.S. Patent No. 6,022,414, increases the amount of chemical species that produce non-preferential films, but leads to high overall deposition rates. The inventors have discovered that a wider deposition region allows increased time for the formation of the chemical species needed for the preferential deposition that results in bottom-up trench filling.

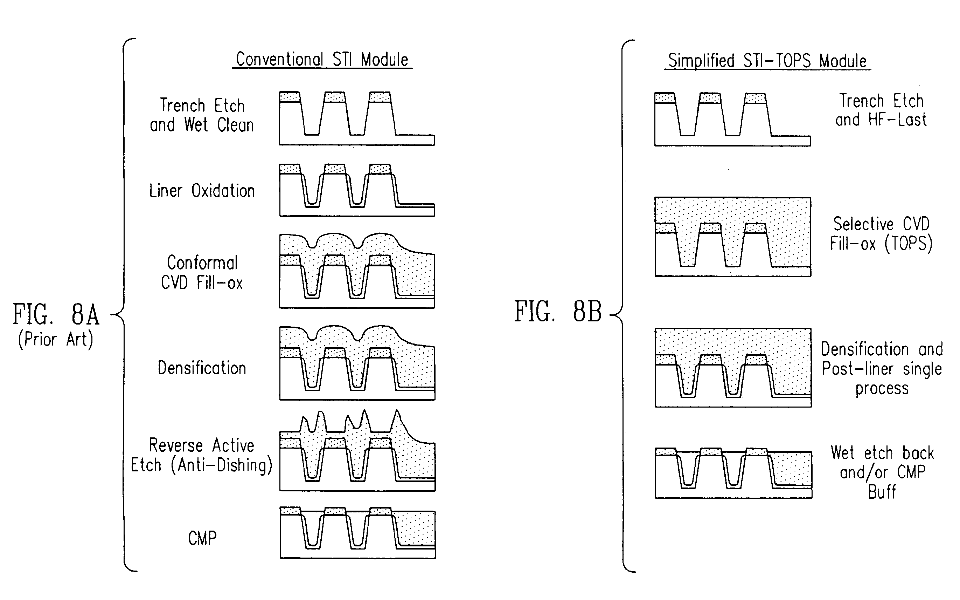

As noted above, the conventional STI process sequence (also referred to in the prior art as "process module") requires the use of an expensive and time-consuming "reverse active" mask. The present invention provides a method and CVD system that promotes the selective/preferential deposition characteristics of the CVD reaction to eliminate the need for the reverse active mask. This method of the present invention causes the isolation trenches to "fill from the bottom up". Bottom-up filling, coupled with post-USG deposition formation of the thermal-oxide liner eliminates the need for the reverse-active mask. This new method significantly reduces STI process module complexity as indicated in Figures 8A and 8B while reducing the module cost by as much as 50%. The number of process steps declines from six to four by using a system and method of the present kind. Within the art of semiconductor fabrication this is regarded as a very substantial improvement. The inventive process sequence produced by an injector embodying the invention as illustrated in Figure 8B may reduce production costs by more than 50% when compared to the prior art process sequence shown in Figure 8A. The apparatus of the present invention may preferably be used in conjunction with the method described in U.S. Patent No. 6,387,764, also owned by the assignee, the disclosure of which is herein incorporated by reference. In particular, injectors and systems as proposed herein can significantly increase the amount of the preferentially depositing chemical species which improves productivity of the process sequence.

The following two detailed descriptions of exemplary embodiments of the present invention are provided to illustrate and further explain advantages and features of the invention. They are in no way intended to limit or otherwise restrict the scope of the invention.

A bi-directional injector system is provided for delivery of one or more gaseous organosilicon compounds, such as for example tetraethyl orthosilicate, and one or more oxidizing compounds, such as for instance ozone, to a reaction region 20 above a substrate surface 12. The injector member 40 is formed of a single elongated member that has at least two end surfaces and an elongated external gas delivery surface comprising two rounded side regions 42 and a center recessed region. The total width of the rounded side regions 42 and the center region is preferably in the range of approximately 50-200 mm. The gas delivery surface extends along the length of the injector member 40 directly facing the substrate surface 12. At least a first thin, elongated injector slot 14 of substantially constant width is formed in the single elongated member and extending between the end surfaces for receiving a gas. This injector slot 14 extends carries gas for distribution in a continuous, unobstructed manner into the reaction region 20. At least two elongated exhaust passageways 22 of substantially constant width are also formed in the elongated member. These exhaust passageways 22 extend directly along the edge of each of the rounded side regions 42 and are positioned as far as possible from the center recessed region. The exhaust passageways remove spent gas by-products from the reaction region 20.

Optionally, the bi-directional system may further include a second elongated passage formed in the elongated injector member 40 and extending between the end surfaces for receiving an etchant species and a second thin, elongated injector slot 14 formed in the injector member 40 and extending directly between the exhaust passageways 32 and the rounded side region or regions 42 of the gas delivery surface for carrying the etchant species from the second injector slot 14 and distributing the etchant species into the reaction region directed away from the center recessed region and towards the sides of the injector member 40.

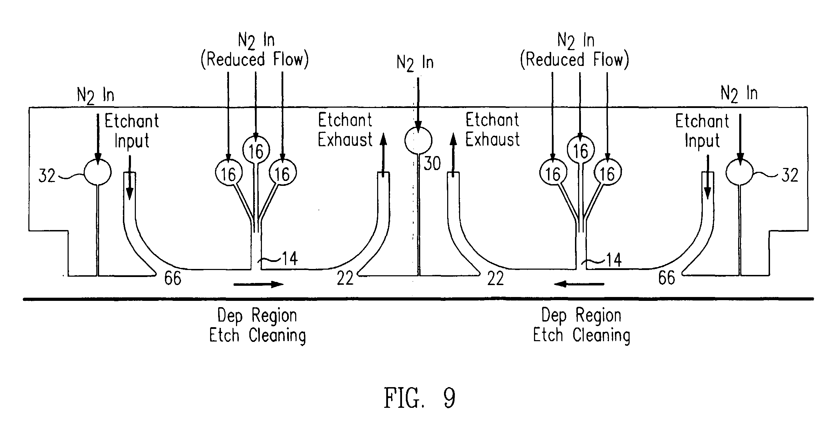

In a further optional embodiment of the bi-directional injector system, gas flow is reversible in one or more of exhaust passageways 22. Gas flow in these reversible exhaust outlet passageways may be reversed such that gas may flow in a typical direction for receiving an etchant gas in at least one of the exhaust outlet passageways while gas flow inward through at least one of the exhaust outlet passageways simultaneously flows in a direction opposite to the typical direction to remove spent etchant byproducts from the reaction region 20. The flow inside the reactant gas (for example, Si and O₃) slots 16 is converted to a small inert gas (N₂) flow of 5%-20% of the normal reactive gas rates. According to this embodiment, flows of the reactive gases are turned off and replaced with about 10% N₂ flow. Next, an etchant reactant gas is introduced into reversed-flow exhaust slots 66 near inert gas inputs 32. The etchant gas then moves thru the deposition region 20 in one direction only, until it reaches the exhaust slots 22 nearest the interior N₂ isolation input 30. The unreacted etchant and the now-gaseous cleaning by products are removed from the deposition region 20 by exhausting thru the two central exhaust slots as shown Figure 9. Details of the etch-clean chemical reaction may be found in Patent Number WO0103858. The etchant flows may preferably be in either direction through reaction region 20 and may be in the same or in mirrored directions in adjacent flow cells.

In an alternative embodiment, a unidirectional injector system for delivery of gaseous organosilicon compounds, such as for instance tetraethyl orthosilicate, and one or more oxidizing compounds, such as for instance ozone, to a substrate surface in a reaction region is provided. The injector system includes a single elongated injector member 40 having at least two end surfaces 42 and an elongated external gas delivery surface comprising one rounded side region and an edge recessed region. The total width of the rounded side region and the edge recessed region is preferably in the range of approximately 25-100 mm. The gas delivery surface extends along the length of the elongated member directly facing the substrate.

At least a first elongated passage or injector slot 14 is formed in said elongated member. The injector slot 14 extends between the end surfaces for receiving a gas. Also formed in the elongated member is at least a first thin, elongated distribution slot of substantially constant width extending directly between the first elongated passage and the edge recessed region of the gas delivery surface for carrying gas directly from the elongated passage for distribution in a continuous, unobstructed manner into the reaction region 20. At least one second elongated exhaust passageway 32 of substantially constant width is formed in the elongated member for removing spent gas by-products from the reaction region 20. It extends directly along the edge of the rounded side region 42 and is positioned as far as possible from the edge recessed region.

In an optional further embodiment of the unidirectional injector system, the system also includes at least a second exhaust passageway formed in the elongated injector member extending between the end surfaces for receiving an etchant species. At least a second thin, elongated injector slot is formed in the single elongated member. It extends directly between the at least one second elongated passage and the rounded side regions of the gas delivery surface for carrying the etchant species from the second elongated passage and distributing the etchant species along the elongated external gas delivery surface directed away from the edge recessed region and towards the sides of the injector member 40.

### EXPERIMENTAL

Further testing of the various embodiments of the present invention disclosed above was conducted to examine overall performance criteria. These criteria include many factors beyond the desired preferential deposition including particulate generation, film shrinkage, ease of in situ injector cleaning, and extension of well developed bi-directional flow process parameters.

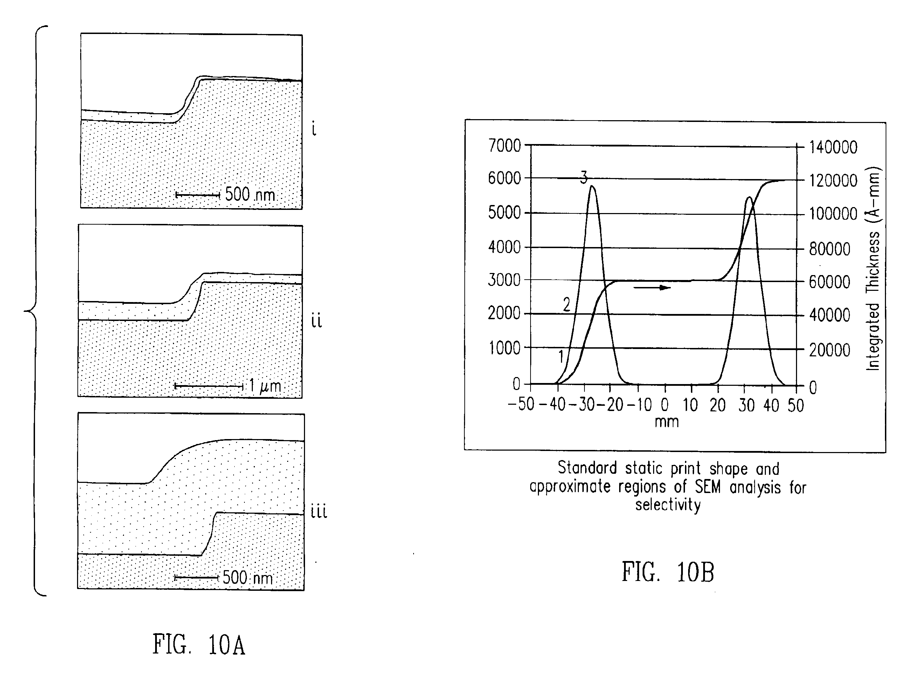

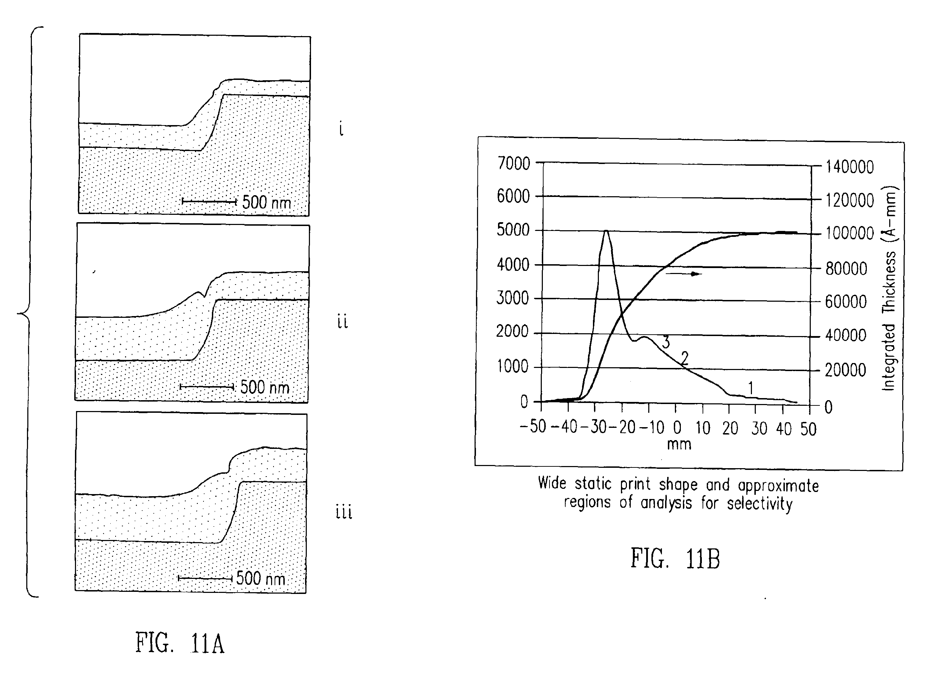

Figures 10A and 10B and Figures 11A and 11B illustrate the results of experiments indicating that a wider deposition region can be used to manage deposition preferentiality. The scanning electron microscope (SEM) photos presented in panels i, ii, and iii of Figure 10A show static substrate deposition on a wide step microstructure with a silicon surface at lower left and a SiNy surface at upper right from a prior art injector configured for standard CVD as shown in Figure 7A. Linear injectors are positioned at approximately 30 mm on either side of the horizontal apparatus-centerline (0 mm on the x-axis of Figure 10B). That is, the gas injection outlet centerlines are located at -30mm and +30mm in figure 10B. As the SEM photos in Figure 10A and the deposition and integrated film thickness traces in Figure 10B demonstrate, film deposition is localized in the reaction regions directly beneath each of the two linear injectors. Reactive chemical species are efficiently removed from the reaction regions though exhaust passages , so deposition effectively drops to zero in the area between the two reaction regions. All three static print sub regions (traces 1, 2, and 3 in Figure 10B) exhibit no indication of preferential deposition.

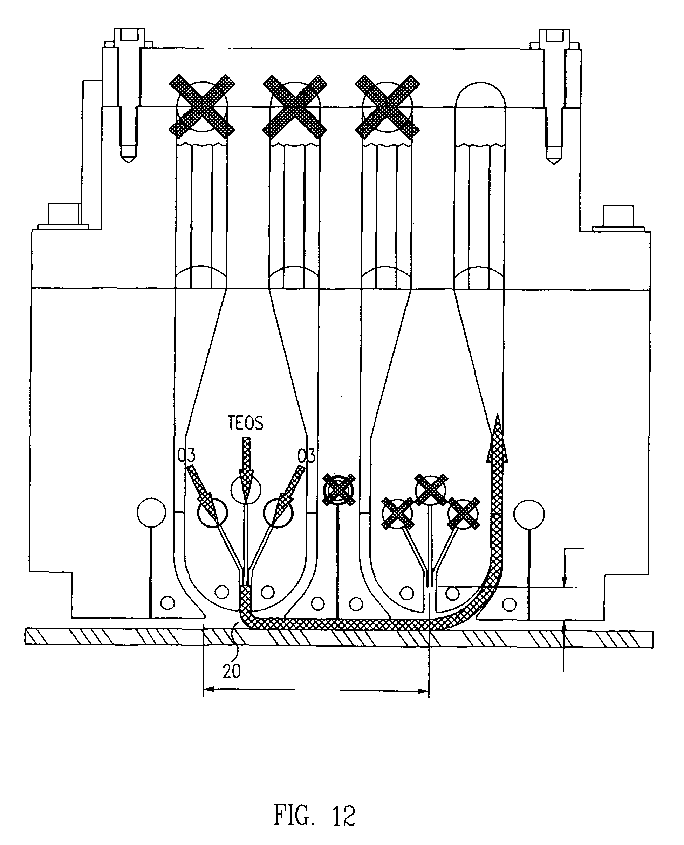

Figures 11A and 11B respectively show SEM photos and traces of deposition rates and integrated film thickness for a substrate similar to that shown in Figure 10A. In this experiment, a uni-directional injector embodying the present invention as shown in Figure 12 was used. In this case the physical width of the unidirectional deposition region 20 was about 75mm. Note that the non-zero portion of the graph Figure 11B, depicting the chemical-deposition width, is approximately 78 mm; very nearly equal to the physical width. As shown in panels i, ii, and iii of Figure 11A, the SiO_{X} region of the substrate accumulates a thicker layer of the deposited film than the SiN_{Y} region. Figure 11B graphically depicts how the deposition rate as a function of position on the static substrate has a tail that is not present in Figure 10B. Additionally, the integrated thickness trace shows a continuing accumulation of film thickness even as far as approximately 60 mm to 70 mm past the gas injection outlet centerline (noted at -30mm in Figure 11B). All three injector print regions in Figure 11B reveal at least some preferential behavior. The location of sub region 3 suggests that preferentiality begins somewhere beyond 15 mm away from the injector outlet centerline. The present invention provides in part for preferential deposition by extending the width of the linear injector deposition. Preferential-deposition in Figure 11B, when compared to the bulk deposition of Figure 10B, is related to: the "kink" associated with sub-region 3, the moderately sloped "linear" region that defines sub-region-2, and the shallow-sloped "tail" of sub-region 1. The SEM photos in Figure 10A indicate that, when moving from sub-region 3 to sub-region, preferentiality improves, and deposition rate degrades. Thus the width of the deposition region 20 should adjusted to optimize the mutually exclusive combination of high-preferentiality and high-deposition rates.

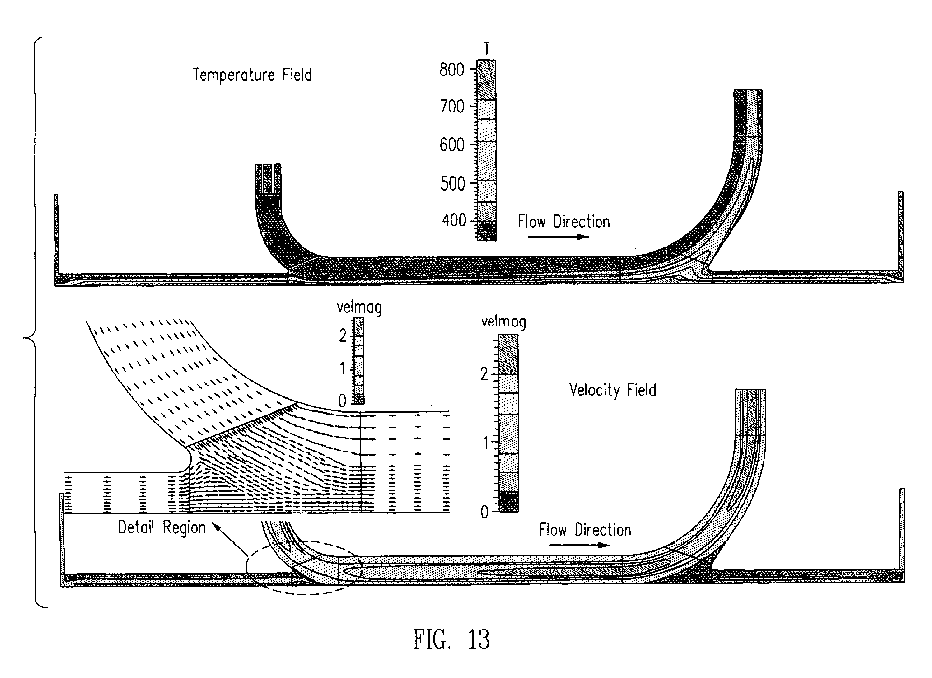

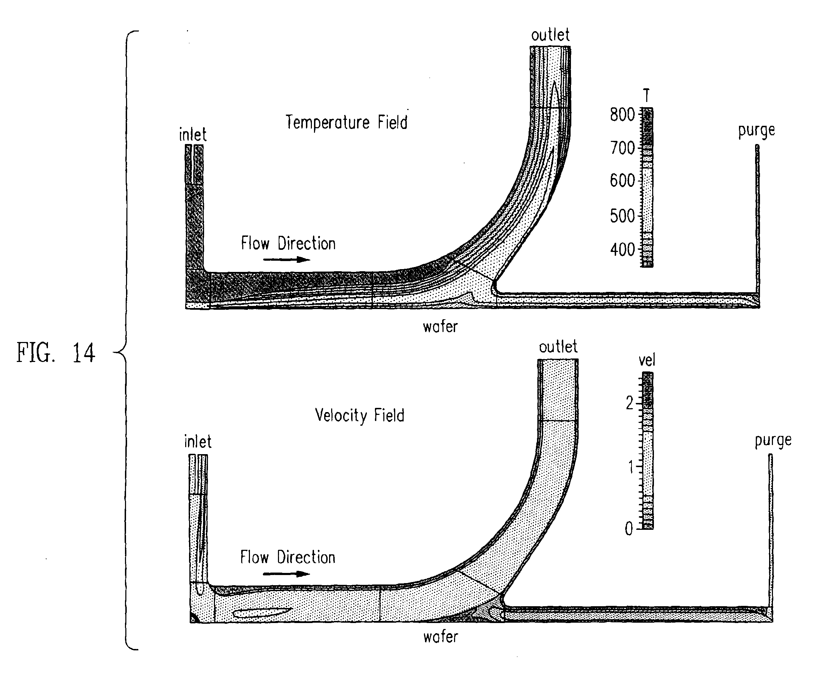

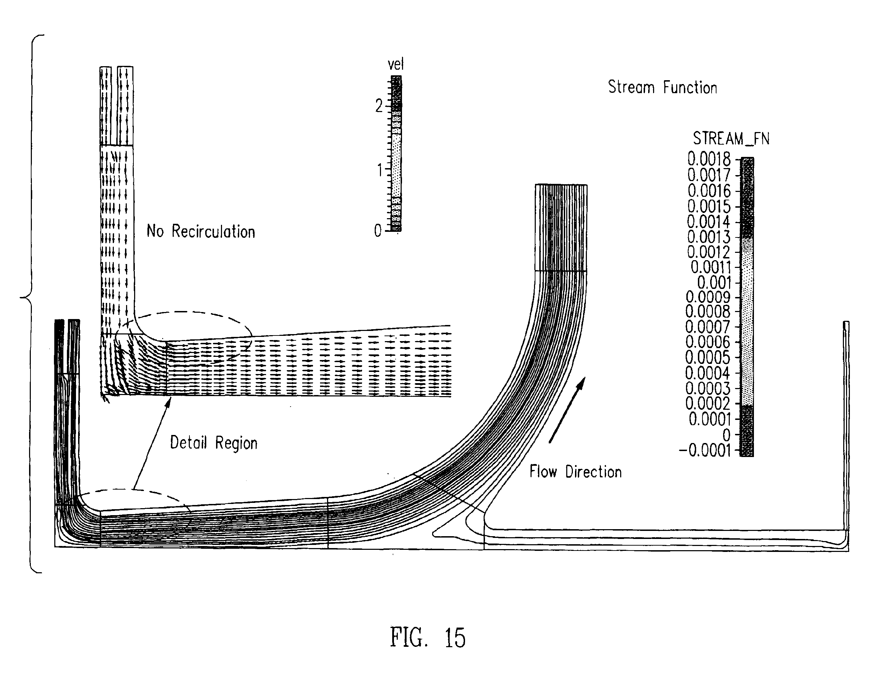

As noted above in the detailed description, the flow within the preferential deposition region may preferably be unidirectional as indicated in Figure 4A, or bi-directional as indicated in Figure 4B. In both Figure 4A and 4B, the dashed box labeled "CFD modeling region" indicates the flow path that was examined by Computational Fluid Dynamics (CFD) modeling to ensure a gas-recirculation-free flow path as follows. The CVD systems and injectors of the present invention were examined via computational flow dynamics (CFD) modeling using the "CFD-ACE" software package from CFD Research Corporation and Chemkin by Reaction Design. Additional algorithms developed by ASML US, Inc. staff were also employed. The primary benefit of CFD modeling is pre-hardware elimination of gas recirculation within the critical deposition region. Recirculation can lead to the formation of small airborne particles. These particles can then fall on to the substrate surface. Particulate contamination of this sort is generally regarded within the semiconductor processing industry as extremely detrimental to electronic circuit operation. Figures 13 to 15 show CFD modeling results for one example of the unidirectional (Figure 13) and one example of the bi-directional (Figure 14 and Figure 15) embodiments of the present invention as depicted in Figures 4A and 4B, respectively. In each case, the stream function and detailed velocity vector plots produced by the model output revealed no indications that recirculation would occur in the reactive gas flow path. CFD modeling packages are well-known in the art, for example CFD Research Corp. and Fluent, Inc., and may be used to optimize the size of the preferential deposition region and chemical deposition by routine computer simulation.

Thus, a significant improvement to the semiconductor industry has been provided. Exemplary embodiments have been described with reference to specific configurations. Those skilled in the art will appreciate that various changes and modifications can be made while remaining within the scope of the claims.

The foregoing description of specific embodiments and examples of the invention have been presented for the purpose of illustration and description, and although the invention has been illustrated by certain of the preceding examples, it is not to be construed as being limited thereby. They are not intended to be exhaustive or to limit the invention to the precise forms disclosed, and obviously many modifications, embodiments, and variations are possible in light of the above teaching. It is intended that the scope of the invention encompass the generic area as herein disclosed, and by the claims appended hereto and their equivalents.

## Claims

1. A chemical vapor deposition system for depositing a film on a substrate surface having at least an area of a first material and at least an area of a second material, comprising:
an injector, said injector providing one or more gases to a reaction region, said one or more gases having a residence time in said reaction region sufficient to promote formation of one or more target chemical species by reaction of said one or more gases, said one or more target chemical species depositing on said first material at a faster rate than on said second material.

2. The chemical vapor deposition system of claim 1 wherein said residence time is a function of the volume of said reaction region and a gas exhaust rate from said reaction region.

3. The chemical vapor deposition system of claim 1 or 2 wherein said reaction region has a volume defined by at least a top wall and a substrate support, and said reaction volume receives said one or more gases delivered by said injector through said top wall.

4. The chemical vapor deposition system of claim 4 further comprising a conveyor mechanism for translating said substrate support at a lateral velocity through said reaction region at least once such that said substrate surface is exposed to said one or more target chemical species for a desired period that is a function of both said residence time and said lateral velocity.

5. The chemical vapor deposition system of claim 1 wherein said injector includes an elongated gas delivery slot through which said one or more gases are delivered.

6. The chemical vapor deposition system of claim 5 further comprising:
at least a first exhaust passage for receiving exhaust gases from said reaction volume, said exhaust passage comprising a channel aligned substantially parallel to said elongated gas delivery slot; and
a conveyor mechanism for translating said substrate surface at least once through said reaction chamber in a direction that is substantially perpendicular to said injector slot and said exhaust passage.

7. The chemical vapor deposition system of claim 6 wherein said injector further comprises:
a single elongated member, said member having at least two end surfaces and an elongated external gas delivery surface.

8. The chemical vapor deposition system of claim 7 wherein said elongated external gas delivery surface further comprises:
two rounded side regions and a center recessed region, wherein the total width of the rounded side regions and the center region is in the range of approximately 50-200 mm and said gas delivery surface extends along the length of said member directly facing said reaction region.

9. The chemical vapor deposition system of claim 1 wherein one of said one or more gases is tetraethyl orthosilicate.

10. The chemical vapor deposition system of claim 1 wherein one of said one or more gases is ozone.

11. The chemical vapor deposition system of claim 1 wherein said substrate is a semiconductor wafer.

12. A method of depositing a film on a substrate surface having at least an area of a first material and an area of a second material, comprising the steps of:
delivering one or more gases at a first flow rate to a reaction region, said reaction region having a volume;
allowing said one or more reactant gases to react to form a gas mixture of one or more target chemical species and one or more waste gases;
exhausting said gas mixture from said reaction region at an exhaust flow rate;
controlling the ratio of said exhaust and said first flow rates relative to said reaction region volume such that the residence time of said one or more gases in said reaction region is sufficient to promote formation of one or more target chemical species from said one or more gases, said one or more target chemical species depositing at a faster rate on said first material than on said second material; and
translating said substrate at least once through said reaction region to expose said surface to said one or more target chemical species.

13. The method of claim 12 wherein said waste gases comprise:
byproducts of the reaction of said one or more reactant gases, unreacted reactant gases, and undeposited target chemical species.

14. A method of claim 12 or 13 carried out in a system according to any one of claims 1 to 11.

15. A method of any one of claims 12 to 14 in which the substrate is a semiconductor wafer having trench regions, with one said material in the trench regions and the other said material on adjacent surface regions.

16. A method according to claim 15 comprising a thermal oxidation step forming an oxide liner layer in the trench regions, either before or after depositing the film.
